# EUROPEAN PATENT APPLICATION

(11) **EP 4 679 992 A1**
(43) Date of publication of application: **14.01.2026**
(21) Application number: 25187033.3
(22) Date of filing: 02.07.2025
(51) Int. Cl.: H10K 59/80, H10K 50/844, H10K 50/86, H10K 59/40

(54) **DISPLAY DEVICE AND METHOD FOR FABRICATING THE SAME**

(30) Priority: 05.07.2024 KR 20240088912
(71) Applicant: Samsung Display Co., Ltd., Yongin-si, Gyeonggi-do 17113 (KR)
(72) Inventor: SUNG, Woo Yong, Yongin-si (KR); SONG, Seung Yong, Yongin-si (KR)
(74) Representative: Marks & Clerk LLP

(57) **Abstract**

A display device includes a substrate (110) including an emission area (EA) and a non-emission area (NLA); a display element layer (150) including an emissive layer (EL) disposed on the emission area of the substrate; a thin-film encapsulation layer (170) disposed on the display element layer, where the thin-film encapsulation layer includes a first encapsulation layer (171), a second encapsulation layer (173), and a third encapsulation layer (175); and a polarizing film (190) disposed on the thin-film encapsulation layer. The third encapsulation layer includes a first layer (175a) having pores; a second layer (175b) disposed on the first layer and having a higher film density than the first layer; and a third layer (175c) disposed on the second layer and having pores.

## Description

### BACKGROUND

### 1. Field of Disclosure

Embodiments of the disclosure relate to a display device and a method of fabricating the display device.

### 2. Description of the Related Art

As the information-oriented society evolves, various demands for display devices are ever increasing. For example, display devices are being employed by a variety of electronic devices such as smart phones, digital cameras, laptop computers, navigation devices, and smart televisions.

Recently, a touch member that can detect a touch input is employed in a display device for smart phones and tablet computers. Such a touch member may be formed directly on a display panel to simplify the process and reduce the thickness of the display device.

Such a display device typically includes a display panel for generating and displaying images and various input means. Recently, a touch panel that recognizes a touch input has been widely employed for display devices of smart phones or tablet computers. A touch panel determines whether a touch input is received, and, if any, finds the coordinates of the position of the touch input.

### SUMMARY

Embodiments of the disclosure provide a method for addressing the reliability issue of display devices.

These and other embodiments of the disclosure will become apparent to those of ordinary skill in the art upon review of the detailed description and claims to follow.

One or more embodiments of the invention described in this specification are set forth in the accompanying drawings and the description below.

In an embodiment of the disclosure, a display device includes a substrate including an emission area and a non-emission area; a display element layer including an emissive layer disposed on the emission area of the substrate; a thin-film encapsulation layer disposed on the display element layer, where the thin-film encapsulation layer includes a first encapsulation layer, a second encapsulation layer, and a third encapsulation layer; and a polarizing film disposed on the thin-film encapsulation layer, where the third encapsulation layer includes a first layer having pores; a second layer disposed on the first layer and having a higher film density than the first layer; and a third layer disposed on the second layer and having pores.

In an embodiment, each of the first layer, the second layer and the third layer may include oxygen-doped silicon nitride.

In an embodiment, the third layer may have a lower film density than the second layer.

In an embodiment, a film density of each of the first layer and the third layer may be equal to or less than about 1.9 grams per cubic centimeter (g/cm³), and a film density of the second layer may be equal to or greater than about 1.9 g/cm³ and equal to or less than about 2.2 g/cm³.

In an embodiment, the first layer and the third layer may have a compressive stress of about -200 megapascals (MPa) or less, and the second layer may have a compressive stress in a range of about -250 MPa to about -150 MPa.

In an embodiment, the second layer may have a porosity lower than a porosity of the first layer and a porosity of the third layer.

In an embodiment, an oxygen content of the second layer may be in a range of about 10% to about 20%, and an oxygen content of the first layer and the third layer may be equal to or less than about 10%.

In an embodiment, a thickness of the first layer and a thickness of the third layer may be less than a thickness of the second layer.

In an embodiment, the thickness of the first layer and the thickness of the third layer may be in a range of about 10% to about 15% of a total thickness of the third encapsulation layer.

In an embodiment, the pores of the first layer may be uneven, and the pores of the third layer may be uneven.

In an embodiment, the second encapsulation layer may include an organic material, and the polarizing film may include an iodine ion.

In an embodiment, the first layer may be in contact with the second encapsulation layer, and the third layer may be in contact with the polarizing film.

In an embodiment, the display device may further include a touch sensor layer disposed between the thin-film encapsulation layer and the polarizing film, where the touch sensor layer may include a first touch layer and a second touch layer disposed on the first touch layer, where second touch layer may have pores, and be in contact with the polarizing film, and a film density of the second touch layer may be lower than a film density of the first touch layer.

In an embodiment, the film density of the first touch layer may be equal to or greater than about 1.9 g/cm³ and equal to or less than about 2.2 g/cm³, and the film density of the second touch layer may be equal to or less than about 1.9 g/cm³.

In an embodiment of the disclosure, an electronic device includes a display panel including a display area and a non-display area surrounding the display area, where the display area comprises a substrate comprising an emission area and a non-emission area; a display element layer including an emissive layer disposed on the emission area of the substrate; a thin-film encapsulation layer disposed on the display element layer, where the thin-film encapsulation layer includes a first encapsulation layer, a second encapsulation layer, and a third encapsulation layer; and a polarizing film disposed on the thin-film encapsulation layer, where the third encapsulation layer may include a first layer having pores; a second layer disposed on the first layer and having a higher film density than the first layer; and a third layer disposed on the second layer and having pores.

In an embodiment of the disclosure, a method for fabricating a display device includes forming a first encapsulation layer including an inorganic material on a substrate, forming a second encapsulation layer including an organic material on the first encapsulation layer, and then forming a third encapsulation layer including a plurality of different layers on the second encapsulation layer; and forming a polarizing film on the third encapsulation layer, where the third encapsulation layer includes: a first layer in contact with the second encapsulation layer and having pores; a second layer disposed on the first layer and having a higher film density than the first layer; and a third layer disposed on the second layer and in contact with the polarizing film and having pores.

In an embodiment, the first layer may absorb outgas generated in the second encapsulation layer in the pores thereof.

In an embodiment, a film density of the third layer may be lower than that of the second layer.

In an embodiment, the third layer may absorb ammonia (NH₃) gas in the pores thereof.

In an embodiment, the forming the third encapsulation layer may include: forming the first layer, the second layer and the third layer in a same chamber.

At least some of the above and other features of the invention are set out in the claims.

According to an embodiment of the disclosure, a thin-film encapsulation layer in contact with an organic layer includes an inorganic film having porosity, such that it is possible to improve the reliability of a display device during a fabrication process or reliability evaluation of the display device.

It should be noted that effects of embodiments of the disclosure are not limited to those described above and other effects thereof will be apparent to those skilled in the art from the following descriptions.

### BRIEF DESCRIPTION OF THE DRAWINGS

The above and other features of embodiments of the disclosure will become more apparent by describing in detail embodiments thereof with reference to the attached drawings, in which:
FIG. 1 is a perspective view showing a display device according to an embodiment of the disclosure;
FIG. 2 is a cross-sectional view of the display device of FIG. 1;
FIG. 3 is a plan view showing the arrangement of emission areas located in the display area of the display device of FIG. 2;
FIG. 4 is a cross-sectional view taken along line X1 - X1' of FIG. 3;
FIG. 5 is an enlarged view of area A in FIG. 4;
FIG. 6 is an enlarged cross-sectional view of area C of FIG. 5;
FIG. 7 is an enlarged cross-sectional view of area E of FIG. 5;
FIG. 8 is a cross-sectional view showing another embodiment of the display device of FIG. 1;
FIG. 9 is a cross-sectional view of the display area in the display device of FIG. 8;
FIG. 10 is an enlarged cross-sectional view of area P of FIG. 9;
FIGS. 11 and 12 are cross-sectional views showing an embodiment of a process of fabricating a thin-film encapsulation layer;
FIG. 13 is an enlarged cross-sectional view of area S of FIG. 12;
FIGS. 14 and 15 are cross-sectional views showing an embodiment of a process of fabricating the thin-film encapsulation layer and the polarizing film of FIG. 4;
FIG. 16 is an enlarged, cross-sectional view of area T of FIG. 15;
FIG. 17 is a block diagram of an electronic device according to one embodiment of the present disclosure; and
FIG. 18 is a schematic diagram of an electronic device according to various embodiments of the present disclosure.

### DETAILED DESCRIPTION

The invention now will be described more fully hereinafter with reference to the accompanying drawings, in which various embodiments are shown. This invention may, however, be embodied in many different forms, and should not be construed as limited to the embodiments set forth herein. Rather, these embodiments are provided so that this disclosure will be thorough and complete, and will fully convey the scope of the invention to those skilled in the art. Like reference numerals refer to like elements throughout.

It will be understood that when an element is referred to as being "on" another element, it can be directly on the other element or intervening elements may be present therebetween. In contrast, when an element is referred to as being "directly on" another element, there are no intervening elements present.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, the singular forms "a," "an," and "the" are intended to include the plural forms, including "at least one," unless the content clearly indicates otherwise. Thus, reference to "an" element in a claim followed by reference to "the" element is inclusive of one element and a plurality of the elements. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompass both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). The term such as "about" can mean within one or more standard deviations, or within ± 30%, 20%, 10%, 5% of the stated value, for example.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the disclosure, and will not be interpreted in an idealized or overly formal sense unless expressly so defined herein.

Embodiments are described herein with reference to cross section illustrations that are schematic illustrations of embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Hereinafter, embodiments of the disclosure will be described in detail with reference to the accompanying drawings.

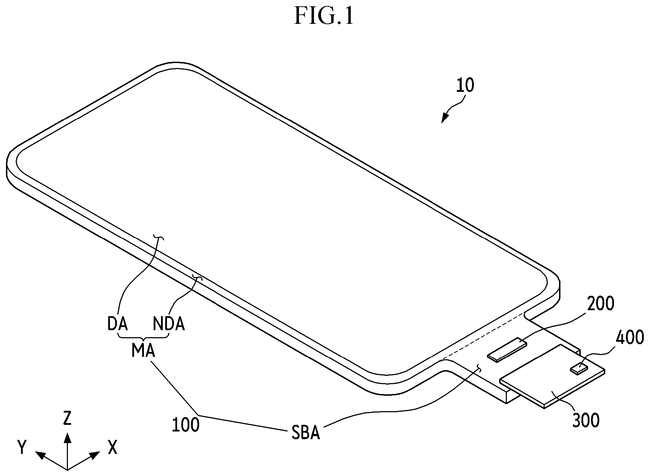

FIG. 1 is a perspective view of a display device according to an embodiment of the disclosure.

Referring to FIG. 1, an embodiment of the display device 10 displays a moving image or a still image. A display device 10 may refer to any electronic device that provides a display screen. For example, the display device 10 may include a television set, a laptop computer, a monitor, an electronic billboard, the Internet of Things (IoT) devices, a mobile phone, a smart phone, a tablet personal computer (PC), an electronic watch, a smart watch, a watch phone, a head-mounted display device, a mobile communications terminal, an electronic notebook, an electronic book, a portable multimedia player (PMP), a navigation device, a game console and a digital camera, a camcorder, etc.

In FIG. 1, a first direction (X-axis direction), a second direction (Y-axis direction) and a third direction (Z-axis direction) are defined. The first direction (X-axis direction) and the second direction (Y-axis direction) may be perpendicular to each other, the first direction (X-axis direction) and the third direction (Z-axis direction) may be perpendicular to each other, and the second direction (Y-axis direction) and the third direction (Z-axis direction) may be perpendicular to each other. The first direction (X-axis direction) may refer to the horizontal direction in a plan view in the drawings, the second direction (Y-axis direction) may refer to the vertical direction in the plan view in the drawings , and the third direction (Z-axis direction) may refer to the up-and-down direction, i.e., a thickness direction of the display device 10 in the drawings. As used herein, a direction may refer to the direction indicated by the arrow as well as the opposite direction, unless specifically stated otherwise. When it is desired to discern between such two opposite directions, one of the two directions may be referred to as "one side in the direction," while the other direction may be referred to as "the opposite side in the direction." In FIG. 1, the side indicated by an arrow indicative of a direction is referred to as one side in the direction, while the opposite side is referred to as the opposite side in the direction.

In the following description of the surfaces of the display device 10, the surface facing one side where images are displayed, i.e., the side indicated by the arrow in the third direction (Z-axis direction) will be referred to as the upper surface, while the opposite surface will be referred to as the lower surface, for convenience of illustration. It should be understood, however, that the disclosure is not limited thereto. The surfaces and the opposite surface of each of the elements may be referred to as a front surface and a rear surface, respectively, or may be referred to as a first surface and a second surface, respectively. In addition, in the description of relative positions of the elements of the display device 10, one side in the third direction (Z-axis direction) may be referred to as the upper side while the opposite side in the third direction (Z-axis direction) may be referred to as the lower side.

The shape of the display device 10 may be modified in a variety of ways. In an embodiment, for example, the display device 10 may have one of shapes (or planar shapes) such as a rectangle with longer lateral sides, a rectangle with longer vertical sides, a square, a quadrangle with rounded corners (vertices), other polygons, a circle, etc. in a plan view or when viewed in the third direction (Z-axis direction).

In an embodiment, as shown in FIG. 1, the display device 10 may include a display panel 100, a display driver 200, a circuit board 300 and a touch driver 400.

The display panel 100 may include a main area MA and a subsidiary area SBA. The main area MA may include the display area DA including pixels for displaying images, and the non-display area NDA located around the display area DA. The main area MA and the subsidiary area SBA may include a flexible material that can be bent, folded, or rolled.

In the display area DA, images can be displayed. In the non-display area NDA, images are not displayed. The display area DA may be referred to as an active area, while the non-display area NDA may also be referred to as an inactive area. The display area DA may generally occupy the center of the display device 10. The non-display area NDA may be located on the outer side of the display area DA. The non-display area NDA may be defined as the edge of the main area MA of the display panel 100. The non-display area NDA may include lines that provide signals to the display area DA, and lines connecting the display driver 200 with the display area DA.

The subsidiary area SBA may extend from one side of the main area MA. When the subsidiary area SBA is bent, the subsidiary area SBA may overlap the main area MA in the thickness direction (e.g., the third direction or Z-axis direction). The subsidiary area SBA may include display pads connected to the display driver 200 and the circuit board 300. According to another embodiment, the subsidiary area SBA may be eliminated, and the display driver 200 and the display pads may be located in the non-display area NDA.

The display driver 200 may output signals and voltages for driving the display panel 100. The display driver 200 may be implemented as an integrated circuit (IC) and may be attached on the display panel 100 by a chip-on-glass (COG) technique, a chip-on-plastic (COP) technique, or ultrasonic bonding. In an embodiment, for example, the display driver 200 may be disposed in the subsidiary area SBA and may overlap the main area MA in the thickness direction as the subsidiary area SBA is bent. In another embodiment, for example, the display driver 200 may be mounted on the circuit board 300.

The circuit board 300 may be attached on the display pads of the display panel 100 using an anisotropic conductive film (ACF). The circuit board 300 may be electrically connected to the display pads. The circuit board 300 may be a flexible printed circuit board (FPCB), a printed circuit board (PCB), or a flexible film such as a chip-on-film (COF).

The touch driver 400 may be mounted on the circuit board 300. The touch driver 400 may output a touch driving signal to drive a plurality of touch electrodes arranged outside or inside the display panel 100.

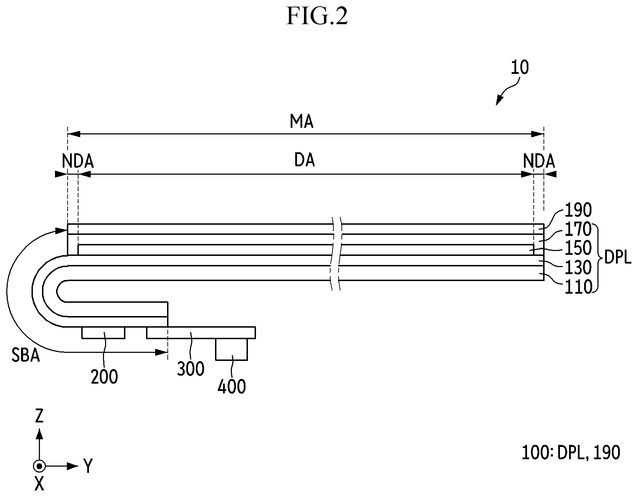

FIG. 2 is a cross-sectional view of the display device of FIG. 1.

Referring to FIG. 2, an embodiment of the display panel 100 may include a display layer DPL and a polarizing film 190. The display layer DPL may include a substrate 110, a thin-film transistor layer 130, a display element layer 150, and a thin-film encapsulation layer 170.

The substrate 110 may be a base substrate or a base member. The substrate 110 may be a flexible substrate that can be bent, folded, or rolled. In an embodiment, for example, the substrate 110 may include, but is not limited to, a polymer resin such as polyimide (PI). According to another embodiment, the substrate 110 may include a glass material or a metal material.

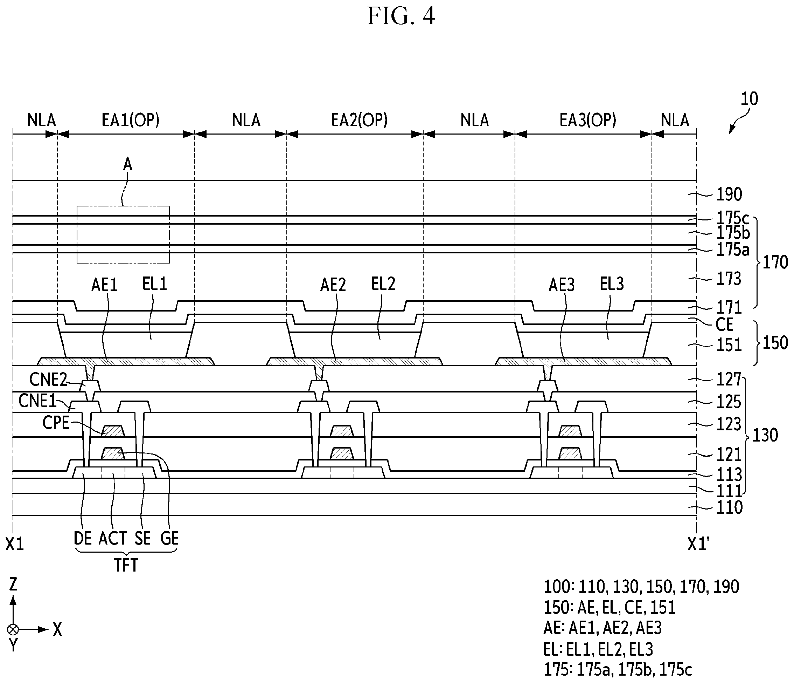

The thin-film transistor layer 130 may be disposed on the substrate 110. The thin-film transistor layer 130 may be disposed in the display area DA, the non-display area NDA and the subsidiary area SBA. The thin-film transistor layer 130 may include a plurality of thin-film transistors TFT (see FIG. 4).

The display element layer 150 may be disposed on the thin-film transistor layer 130. The display element layer 150 may be located in the display area DA. The display element layer 150 may include, but is not limited to, at least one selected from an organic light-emitting diode including an organic emissive layer, a quantum-dot light-emitting diode (quantum LED) including a quantum-dot emissive layer, an inorganic light-emitting diode (inorganic LED) including an inorganic semiconductor, and a micro light-emitting diode (micro LED).

The thin-film encapsulation layer 170 is disposed on the display element layer 150. The thin-film encapsulation layer 170 may be disposed in the display area DA and the non-display area NDA. The thin-film encapsulation layer 170 may cover the upper and side surfaces of the display element layer 150, and can protect the display element layer 150 from outside oxygen and moisture. The thin-film encapsulation layer 170 may include at least one inorganic film and at least one organic film for encapsulating the display element layer 150.

The polarizing film 190 is disposed on the thin-film encapsulation layer 170. The polarizing film 190 may be a feature for effectively preventing deterioration of visibility due to reflection of external light. The polarizing film 190 may include a linear polarizer and a retardation film. In an embodiment, for example, the retardation film may be a λ/4 plate (quarter-wave plate), but the embodiments of the disclosure are not limited thereto.

In an embodiment, as shown in FIG. 2, a portion of the display layer DPL corresponding to the subsidiary area SBA may be bent. When a portion of the display layer DPL is bent, the display driver 200, the circuit board 300 and the touch driver 400 may overlap with the main area MA in the third direction (Z-axis direction).

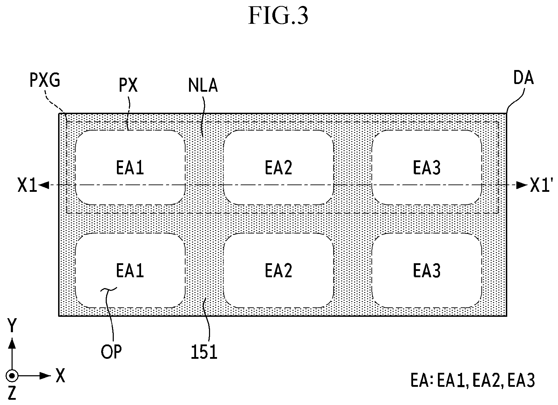

FIG. 3 is a plan view showing the arrangement of emission areas located in the display area of the display panel of FIG. 2.

Referring to FIG. 3, the display area DA according to an embodiment may include emission areas EA and a non-emission area NLA. The non-emission area NLA may be located such that it surrounds the emission areas EA.

The emission areas EA may include first emission areas EA1, second emission areas EA2 and third emission areas EA3 that emit light of different colors. The first emission area EA1, the second emission area EA2 and the third emission area EA3 may emit light of different colors. In an embodiment, for example, the first emission area EA1 may emit red light, the second emission area EA2 may emit green light, and the third emission area EA3 may emit blue light. The colors of light output from the first emission area EA1, the second emission area EA2 and the third emission area EA3 may vary depending on the type of an emissive layer EL (see FIG. 4) described below.

In an embodiment, as shown in FIG. 3, the first to third emission areas EA1, EA2 and EA3 have a same size and shape as each other, but the disclosure is not limited thereto. The size and shape of the first to third emission areas EA1, EA2 and EA3 may be variously adjusted based on desired characteristics.

At least one first emission area EA1, at least one second emission areas EA2 and at least one third emission area EA3 arranged adjacent to each other may form or collectively define a single pixel group PXG. A pixel group PXG may be the minimum unit that emits white light. However, the type and/or number of each of the first to third emission areas EA1, EA2 and EA3 forming a pixel group PXG may vary depending on embodiments.

The non-emission area NLA can block light output from each of the first emission area EA1, the second emission area EA2 and the third emission area EA3. Accordingly, the non-emission area NLA can assist in preventing the light output from the first emission area EA1, the second emission area EA2 and the third emission area EA3 from being mixed.

When viewed from the top or in a plan view, a pixel-defining layer 151 may be located in line with the non-emission area NLA. The pixel-defining layer 151 may define the emission areas EA and the non-emission area NLA. The pixel-defining layer 151 may surround openings OP.

FIG. 4 is a cross-sectional view taken along line X1 - X1' of FIG. 3.

Referring to FIG. 4, in an embodiment, the thin-film transistor layer 130 may be disposed on the substrate 110. The thin-film transistor layer 130 may include a first buffer layer 111, a thin-film transistor TFT, a gate insulator 113, a first insulating layer 121 a capacitor electrode CPE, a second insulating layer 123, a first connection electrode CNE1, a first via layer 125, a second connection electrode CNE2, and a second via layer 127.

The first buffer layer 111 may be disposed on the substrate 110. The first buffer layer 111 can prevent permeation of air or moisture. In an embodiment, for example, the first buffer layer 111 may include an inorganic insulating material.

The thin-film transistor TFT may be disposed on the first buffer layer 111 and may form a pixel circuit connected to each of a plurality of pixels. In an embodiment, for example, the thin-film transistor TFT may be a driving transistor or a switching transistor of the pixel circuit. The thin-film transistor TFT may include an active layer ACT, a source electrode SE, a drain electrode DE and a gate electrode GE.

The active layer ACT may be disposed on the first buffer layer 111. The active layer ACT may overlap the gate electrode GE in the third direction (Z-axis direction) and may be insulated from the gate electrode GE by the gate insulator 113. The material of a part of the active layer ACT may be made conductive such that the source electrode SE and the drain electrode DE may be defined by the part of the active layer ACT.

The gate electrode GE may be disposed on the gate insulator 113. The gate electrode GE may overlap the active layer ACT with the gate insulator 113 interposed therebetween.

The gate insulator 113 may be disposed over the active layer ACT. The gate insulator 113 may cover the active layer ACT and the first buffer layer 111, and may insulate the active layer ACT from the gate electrode GE. The gate insulator 113 may be provided with a contact hole through which the first connection electrode CNE1 passes.

The first insulating layer 121 may cover the gate electrode GE and the gate insulator 113. The first insulating layer 121 may be provided with a contact hole through which the first connection electrode CNE1 passes. The contact hole of the first insulating layer 121 may be connected to the contact hole of the gate insulator 113 and the contact hole of the second insulating layer 123.

The capacitor electrode CPE may be disposed on the first insulating layer 121. The capacitor electrode CPE may overlap the gate electrode GE in the third direction (Z-axis direction). The capacitor electrode CPE and the gate electrode GE may form a capacitance.

The second insulating layer 123 may cover the capacitor electrode CPE and the first insulating layer 121. The second insulating layer 123 be provided with include the contact hole through which the first connection electrode CNE1 passes. The contact hole of the second insulating layer 123 may be connected to the contact hole of the first insulating layer 121 and the contact hole of the gate insulator 113.

The first connection electrode CNE1 may be disposed on the second insulating layer 123. The first connection electrode CNE1 may electrically connect the drain electrode DE of the thin-film transistor TFT with the second connection electrode CNE2. The first connection electrode CNE1 may be disposed in or inserted into the contact hole formed in the first insulating layer 121, the second insulating layer 123 and the gate insulator 113 to be in contact with the drain electrode DE of the thin-film transistor TFT.

The first via layer 125 may cover the first connection electrode CNE1 and the second insulating layer 123. The first via layer 125 may provide a flat surface over the underlying structures. The first via layer 125 may be provided with a contact hole through which the second connection electrode CNE2 passes.

The second connection electrode CNE2 may be disposed on the first via layer 125. The second connection electrode CNE2 may be disposed in or inserted into a contact hole formed in the first via layer 125 to be in contact with the first connection electrode CNE1. The second connection electrode CNE2 may electrically connect the first connection electrode CNE1 with an anode electrode AE.

The second via layer 127 may cover the second connection electrode CNE2 and the first via layer 125. The second via layer 127 may be provided with a contact hole through which the anode electrode AE passes.

The display element layer 150 may be disposed on the second via layer 127. The display element layer 150 may include an anode electrode AE, an emissive layer EL, a cathode electrode CE, and a pixel-defining layer 151.

According to the embodiment, the anode electrode AE may be disposed on the second via layer 127. The anode electrode AE may be electrically connected to the drain electrode DE of the thin-film transistor TFT through the first connection electrode CNE1 and the second connection electrode CNE2.

The anode electrodes AE may include a first anode electrode AE1 disposed in the first emission area EA1, a second anode electrode AE2 disposed in the second emission area EA2, and a third anode electrode AE3 disposed in the third emission area EA3. The first anode electrode AE1, the second anode electrode AE2 and the third anode electrode AE3 may be spaced apart from one another on the second via layer 127.

The anode electrodes AE may have a stack structure of a material layer having a high work function such as indium-tin-oxide (ITO), indium-zinc-oxide (IZO), zinc oxide (ZnO) and indium oxide (In₂O₃), and a reflective material layer such as silver (Ag), magnesium (Mg), aluminium (Al), platinum (Pt), lead (Pb), palladium (Pd), gold (Au), nickel (Ni), neodymium (Nd), iridium (Ir), chromium (Cr), lithium (Li), calcium (Ca) or a mixture thereof. In an embodiment, for example, the anode electrodes AE may have, but the disclosure is not limited to, a multilayer structure of ITO/Mg, ITO/MgF, ITO/Ag, and ITO/Ag/ITO.

According to an embodiment of the disclosure, the emissive layers EL may be disposed on the anode electrodes AE. The emissive layers EL may include a first emissive layer EL1 disposed in the first emission area EA1, a second emissive layer EL2 disposed in the second emission area EA2, and a third emissive layer EL3 disposed in the third emission area EA3. The first emissive layer EL1, the second emissive layer EL2 and the third emissive layer EL3 may emit light of different colors. In an embodiment, for example, the first emissive layer EL1 may emit red light, the second emissive layer EL2 may emit green light, and the third emissive layer EL3 may emit blue light, but the disclosure is not limited thereto.

According to the embodiment, the cathode electrode CE may be located on the emissive layer EL in the emission areas EA and the non-emission area NLA. The cathode electrode CE may be a common electrode. Accordingly, the cathode electrode CE may entirely cover the first emissive layer EL1, the second emissive layer EL2 and the third emissive layer EL3.

The cathode electrode CE may receive a common voltage or a low-level voltage. In such an embodiment, when the anode electrode AE receives the voltage equal to the data voltage and the cathode electrode CE receives the low-level voltage, a potential difference is formed between the anode electrode AE and the cathode electrode CE, so that light can be emitted from the emissive layers EL.

According to an embodiment, the pixel-defining layer 151 may be located in line with the non-emission area NLA. The pixel-defining layer 151 may be disposed on the second via layer 127 and may cover the edge of the anode electrode AE.

In the cross section, the pixel-defining layer 151 may define the emission areas EA and the non-emission area NLA. In a plan view, the pixel-defining layer 151 may surround openings OP and may expose the anode electrodes AE through the openings OP. The openings OP may be located in line with the emission areas EA.

According to an embodiment of the disclosure, the thin-film encapsulation layer 170 is disposed on the display element layer 150. The thin-film encapsulation layer 170 may be disposed in the emission areas EA and the non-emission area NLA. The thin-film encapsulation layer 170 may include a first encapsulation layer 171, a second encapsulation layer 173, and a third encapsulation layer 175 sequentially stacked on one another.

According to an embodiment, the first encapsulation layer 171 may be disposed on the cathode electrode CE. The first encapsulation layer 171 has a uniform thickness along the profile of the underlying structures and can cover the underlying structures. Accordingly, the first encapsulation layer 171 may have an uneven upper surface with different levels or heights.

The first encapsulation layer 171 may include one or more inorganic insulating materials. In an embodiment, for example, the first encapsulation layer 171 may include at least one selected from aluminium oxide, titanium oxide, tantalum oxide, hafnium oxide, zinc oxide, silicon oxide, silicon nitride, and silicon oxynitride.

According to an embodiment of the disclosure, the second encapsulation layer 173 may be located on the first encapsulation layer 171. The second encapsulation layer 173 may provide a flat surface over the first encapsulation layer 171 having an upper surface with different levels. The second encapsulation layer 173 can protect the display element layer 150 from particles.

The second encapsulation layer 173 may include an organic material. In an embodiment, for example, the second encapsulation layer 173 may include a silicone resin, an acrylic resin, an epoxy resin, or a mixture thereof.

According to the embodiment of the disclosure, the third encapsulation layer 175 may be located on the second encapsulation layer 173. The third encapsulation layer 175 may entirely cover the second encapsulation layer 173. The third encapsulation layer 175 may include multiple layers having different roles. In an embodiment, the third encapsulation layer 175 includes a first layer 175a, a second layer 175b, and a third layer 175c. The first layer 175a, the second layer 175b and the third layer 175c may be stacked on one another sequentially. The third encapsulation layer 175 may include a porosity layer. More detailed descriptions thereof will be given below.

In the process of fabricating the display device 10, the first layer 175a, the second layer 175b and the third layer 175c may be formed consecutively in a same process. Such a fabrication process will be described later in greater detail.

The polarizing film 190 is disposed on the thin-film encapsulation layer 170. The polarizing film 190 may entirely cover the thin-film encapsulation layer 170. The polarizing film 190 may include an iodinated organic material. Any repetitive detailed descriptions thereof will be omitted.

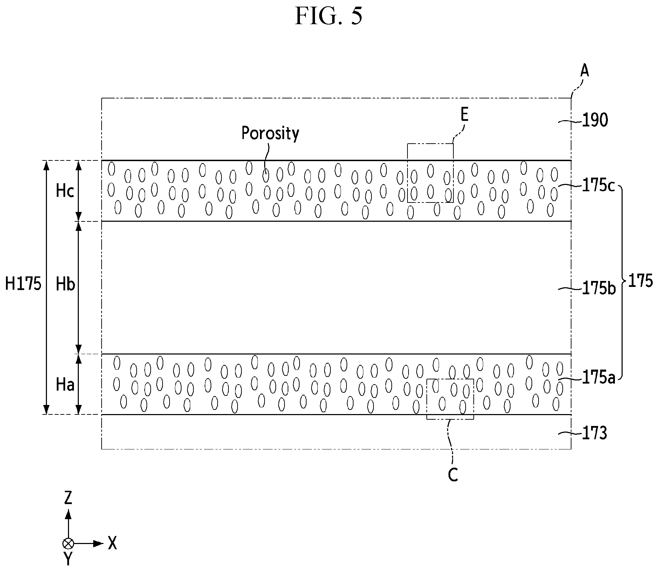

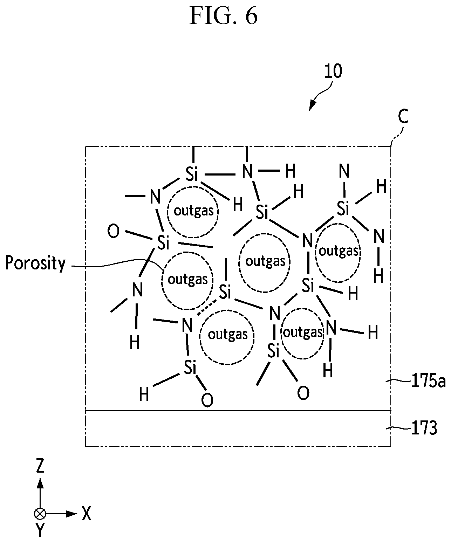

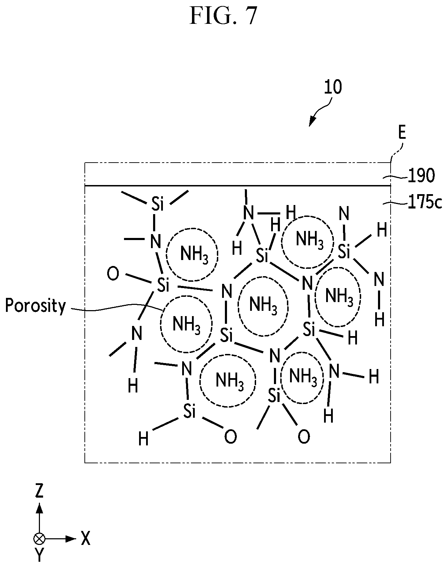

FIG. 5 is an enlarged cross-sectional view of area A of FIG. 4. FIG. 6 is an enlarged cross-sectional view of area C of FIG. 5. FIG. 7 is an enlarged cross-sectional view of area E of FIG. 5.

Referring to FIGS. 5 to 7, the third encapsulation layer 175 according to an embodiment may include an inorganic insulating material. In an embodiment, for example, the third encapsulation layer 175 may include silicon nitride. It should be noted that the third encapsulation layer 175 may include silicon nitride, and may include a certain range of oxygen in the film. In an embodiment, the first layer 175a, the second layer 175b and the third layer 175c may include silicon nitride doped with oxygen.

According to the embodiment, the first layer 175a may be located on the second encapsulation layer 173. The first layer 175a has pores. The pores of the first layer 175a may mean voids within chemical bonds. The pores may be uneven, and its size or shape may also be uneven. The term "having pores" may be used interchangeably with various terms such as "having porosity, porous, or pore quality". The term porosity may mean a percentage of void space in a layer. In other words, the first layer 175a may also be referred to as a porous inorganic film.

According to an embodiment, the second layer 175b is disposed on the first layer 175a. The second layer 175b may include a denser inorganic film than the first layer 175a. In such an embodiment, the second layer 175b has a higher film density than the first layer 175a. In an embodiment, for example, the film density of the first layer 175a may be equal to or less than about 1.9 grams per cubic centimeter (g/cm³), and the film density of the second layer 175b may be in a range of about 1.9 g/cm³ to about 2.2 g/cm³.

In an embodiment, as shown in FIG. 5, the second layer 175b may not have porosity, that is, no pore exists in the second layer 175b, but the disclosure is not limited thereto. In an embodiment, the second layer 175b may have a porosity lower than that of the first layer 175a.

The second layer 175b may effectively prevent permeation of moisture from the outside. In an embodiment, for example, the water vapor transmission rate (WVTR) of the second layer 175b may be equal to or less than 10⁻³ gram per square meter per day (g/m²·day). In addition, the second layer 175b can increase the interfacial adhesive strength such that the first layer 175a and the third layer 175c are not easily physically separated.

The aforementioned water vapor transmission rate (WVTR) can be measured using a Water Vapor Transmittance Tester. The Water Vapor Transmittance Tester consists of an inner chamber filled with N₂ and an outer chamber filled with water vapor, allowing the WVTR of the sample to be measured using the pressure difference of the water vapor.

In an embodiment, for example, the second layer 175b may have a compressive stress in a range of about -250 megapascals (MPa) to about -150 MPa. In an embodiment, for example, the first layer 175a and the third layer 175c may have a compressive stress in a range of about -200 MPa or less.

For example, the aforementioned compressive stress can be measured using a film stress measurement system that employs a laser. Each film is deposited on a pure glass or pure silicon wafer, allowing the thin film stress values within the aforementioned range to be obtained.

According to an embodiment, the third layer 175c is disposed on the second layer 175b and may come into contact with the polarizing film 190. The third layer 175c has pores. In other words, the third layer 175c may also be referred to as a porous inorganic film. The features of pores of the third layer 175c may be identical to the features of pores of the first layer 175a, and any repetitive detailed descriptions thereof will be omitted.

The third layer 175c may have a lower film density than the second layer 175b. In an embodiment, for example, the film density of the third layer 175c may be equal to or less than about 1.9 g/cm³.

The aforementioned film density can be measured using an XRR (X-ray Reflectivity) analysis system. The XRR analysis system uses X-rays as a light source to measure the density of each film.

In some embodiments, the first layer 175a and the third layer 175c may include a lower oxygen content than the second layer 175b. In an embodiment, for example, the oxygen content (e.g., % by weight of oxygen) in the first layer 175a and the third layer 175c may be about 10% or less, and the oxygen content in the second layer 175b may be in a range of about 10% to about 20%.

The aforementioned oxygen content range can be measured using an XPS (X-ray Photoelectron Spectroscopy) analysis system. The XPS analysis system uses X-rays as a light source to measure the elemental composition contained in each film.

In some embodiments, the height (or thickness) Ha of the first layer 175a may be smaller than the height Hb of the second layer 175b. In addition, the height Hc of the third layer 175c may be smaller than the height Hb of the second layer 175b. In an embodiment, for example, the height Ha of the first layer 175a and the height Hc of the third layer 175c may be in a range of about 10% to about 15% of the total height H175 of the third encapsulation layer 175. The height Ha of the first layer 175a may be approximately equal to the height Hc of the third layer 175c, but the disclosure is not limited thereto.

Referring to FIG. 6, the first layer 175a according to an embodiment can absorb outgas by an organic layer in the pores. As described above, the pores of the first layer 175a may mean the voids formed by chemical bonds of silicon (Si), nitrogen (N), oxygen (O), and hydrogen (H) contained in the first layer 175a.

In the process of fabricating the display device 10, the second encapsulation layer 173 containing an organic material may generate outgas. Typically, outgas of the second encapsulation layer 173 may deteriorate the reliability of the display device 10. Therefore, in the display device 10 according to an embodiment of the disclosure, the first layer 175a having pores is formed to be in direct contact with the second encapsulation layer 173 which is an organic layer, such that the outgas generated from the second encapsulation layer 173 may be effectively absorbed in the pores of the first layer 175a. Such a fabrication process will be described later in greater detail.

Referring to FIG. 7, the third layer 175c according to an embodiment may absorb ammonia (NH₃) gas in the pores. As described above, the pores of the third layer 175c may mean the voids formed by chemical bonds of silicon (Si), nitrogen (N), oxygen (O), and hydrogen (H) contained in the third layer 175c.

According to an embodiment, the third layer 175c may include ammonia (NH₃) gas that failed to react on the surface and inside during the fabricating process or reliability evaluation. In such an embodiment, for example, if the ammonia (NH₃) gas contained in the third layer 175c and the iodine ion (I-) contained in the polarizing film 190 react with each other, there may be a defect in that the polarizing film 190 is discolored.

Accordingly, in the display device 10 according to an embodiment of the disclosure, the third layer 175c having pores is formed to be in direct contact with the polarizing film 190 containing iodine ions, such that ammonia (NH₃) gas may be effectively absorbed in the pores of the third layer 175c. Such a fabrication process will be described later in greater detail.

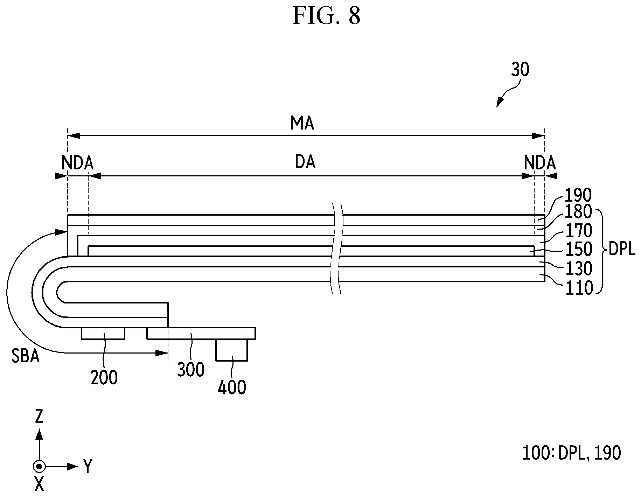

FIG. 8 is a cross-sectional view showing another embodiment of the display device of FIG. 1.

Referring to FIG. 8, a display layer DPL included in a display device 30 according to the embodiment of FIG. 8 may be substantially the same as the display layer DPL included in the display device 10 according to the embodiment of FIG. 2 except that the former includes a touch sensor layer 180 on a thin-film encapsulation layer 170. In such an embodiment, as shown in FIG. 8, the display panel 100 included in the display device 30 may include a substrate 110, a thin-film transistor layer 130, a display element layer 150, a thin-film encapsulation layer 170, a touch sensor layer 180, and a polarizing film 190. In the following description, the descriptions will focus on differences between the display device 30 and the display device 10 and any repetitive detailed description of the same or like elements as those shown in FIG. 2 will be omitted or simplified.

In an embodiment, the touch sensor layer 180 may be disposed on the thin-film encapsulation layer 170. The touch sensor layer 180 may be located across the display area DA and the non-display area NDA. The touch sensor layer 180 may sense a user's touch by mutual capacitance sensing or self-capacitance sensing.

The polarizing film 190 may be positioned on the touch sensor layer 180. The polarizing film 190 may be in contact with the touch sensor layer 180. Any repetitive detailed descriptions thereof will be omitted.

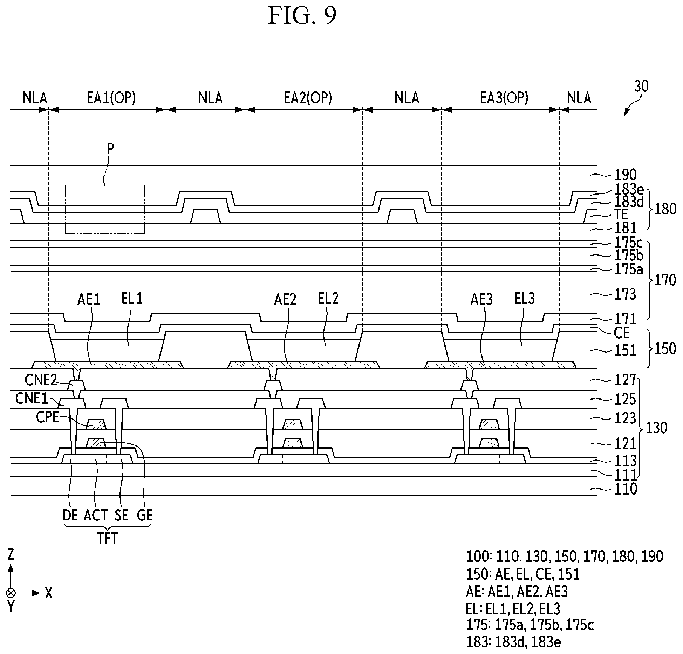

FIG. 9 is a cross-sectional view of the display area in the display device of FIG. 8.

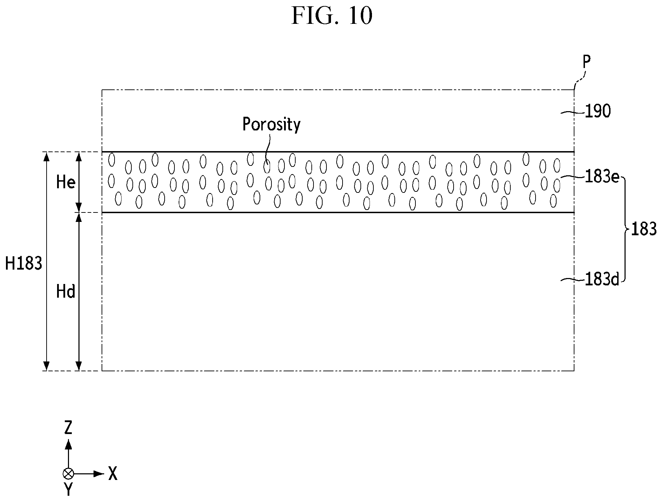

FIG. 10 is an enlarged cross-sectional view of area P of FIG. 9. In the following description, the descriptions will focus on differences between the display device 30 and the display device 10 and any repetitive detailed description of the same or like elements as those shown in FIG. 3 will be omitted or simplified.

Referring to FIG. 9, in an embodiment, the third layer 175c of the third encapsulation layer 175 included in the display device 30 may come into contact with the touch sensor layer 180. The third layer 175c may be entirely covered by the touch sensor layer 180.

According to an embodiment of the disclosure, the touch sensor layer 180 may be disposed on the thin-film encapsulation layer 170. The touch sensor layer 180 may include a touch buffer layer 181, touch electrodes TE and a touch insulating layer 183.

The touch buffer layer 181 may be disposed on the thin-film encapsulation layer 170 and may be eliminated in some implementations. The touch buffer layer 181 may include one or more inorganic insulating materials. In an embodiment, for example, the touch buffer layer 181 may include at least one selected from aluminium oxide, titanium oxide, tantalum oxide, hafnium oxide, zinc oxide, silicon oxide, silicon nitride, and silicon oxynitride.

The touch electrodes TE may be disposed in the non-emission area NLA and may be located on the touch buffer layer 181. The touch electrodes TE may include any electrode capable of sensing a user's touch. The touch electrodes TE may include a conductive metal material. In an embodiment, for example, the touch electrodes TE may include copper (Cu), aluminium (Al), and magnesium (Mg).

The touch insulating layer 183 may be disposed on the touch buffer layer 181 and the touch electrodes TE. The touch insulating layer 183 may entirely cover the touch buffer layer 181 and the touch electrodes TE. The touch insulating layer 183 may include a plurality of layers having different roles (or different physical or chemical properties). The touch insulating layer 183 may include a first touch layer 183d and a second touch layer 183e. The first touch layer 183d and the second touch layer 183e may be stacked on each other sequentially. The touch insulating layer 183 may include a porous layer. More detailed descriptions thereof will be given below.

The polarizing film 190 may be positioned on the touch sensor layer 180. The polarizing film 190 may entirely cover the touch sensor layer 180. Any repetitive detailed descriptions thereof will be omitted.

Referring to FIGS. 9 and 10, the touch insulating layer 183 according to an embodiment may include an inorganic insulating material. In an embodiment, for example, the touch insulating layer 183 may include silicon nitride.

According to an embodiment, the first touch layer 183d and the second touch layer 183e of the touch sensor layer 180 included in the display device 30 may overlap the first layer 175a, the second layer 175b and the third layer 175c of the third encapsulation layer 175 in the third direction (Z-axis direction). The first layer 175a, the second layer 175b and the third layer 175c of the third encapsulation layer 175 included in the display device 30 may have a same structure and characteristics as those of the first layer 175a, the second layer 175b and the third layer 175c of the third encapsulation layer 175 included in the display device 10. Accordingly, any repetitive detailed descriptions thereof will be omitted.

According to an embodiment, the first touch layer 183d may be located in contact with the touch buffer layer 181 and the touch electrodes TE. The first touch layer 183d can prevent permeation of moisture from the outside. In an embodiment, for example, the water vapor transmission rate (WVTR) of the first touch layer 183d may be equal to or less than about 10⁻³ g/m²·day. In addition, the first touch layer 183d can increase the interfacial adhesive strength such that the touch buffer layer 181 and the second touch layer 183e are not easily physically separated. In an embodiment, for example, the first touch layer 183d may have a compressive stress in a range of about -250 MPa to about -150 MPa.

According to an embodiment, the second touch layer 183e may be disposed on the first touch layer 183d and may come into contact with the polarizing film 190. The second touch layer 183e may have pores. In other words, the second touch layer 183e may also be referred to as a porous inorganic film. The features of pores of the second touch layer 183e may be to the same as the features of pores of the first layer 175a of the third encapsulation layer 175 described above. Accordingly, any repetitive detailed descriptions thereof will be omitted.

The second touch layer 183e may have a relatively lower film density than the first touch layer 183d. In an embodiment, for example, the film density of the first touch layer 183d may be in a range of about 1.9 g/cm³ to about 2.2 g/cm³, and the film density of the second touch layer 183e may be equal to or less than about 1.9 g/cm³.

In some embodiments, the second touch layer 183e may include a lower oxygen content than the first touch layer 183d. In an embodiment, for example, the oxygen content in the second touch layer 183e may be about 10% or less, and the oxygen content in the first touch layer 183d may be in a range of about 10% to about 20%.

In some embodiments, the height He of the second touch layer 183e may be smaller than the height Hd of the first touch layer 183d. In an embodiment, for example, the height He of the second touch layer 183e may be in a range of about 10% to about 15% of the height H183 of the touch insulating layer 183.

In an embodiment, as shown in FIG. 10, the first touch layer 183d may not have pores, but the disclosure is not limited thereto. In another embodiment, the first touch layer 183d may include a porosity lower than that of the second touch layer 183e.

According to an embodiment, the second touch layer 183e may include ammonia (NH₃) gas that failed to react on the surface and inside during the fabricating process or reliability evaluation. In such an embodiment, for example, if the ammonia (NH₃) gas contained in the second touch layer 183e and the iodine ion (I-) contained in the polarizing film 190 react with each other, there may be a defect in that the polarizing film 190 is discolored. Accordingly, in the display device 30 according to an embodiment of the disclosure, the second touch layer 183e having pores is formed to be in direct contact with the polarizing film 190 containing iodine ions, so that ammonia (NH₃) gas can be absorbed in the pores of the second touch layer 183e.

Hereinafter, an embodiment of a process of fabricating the thin-film encapsulation layer and the polarizing film of the display device of FIG. 4 will be described in detail.

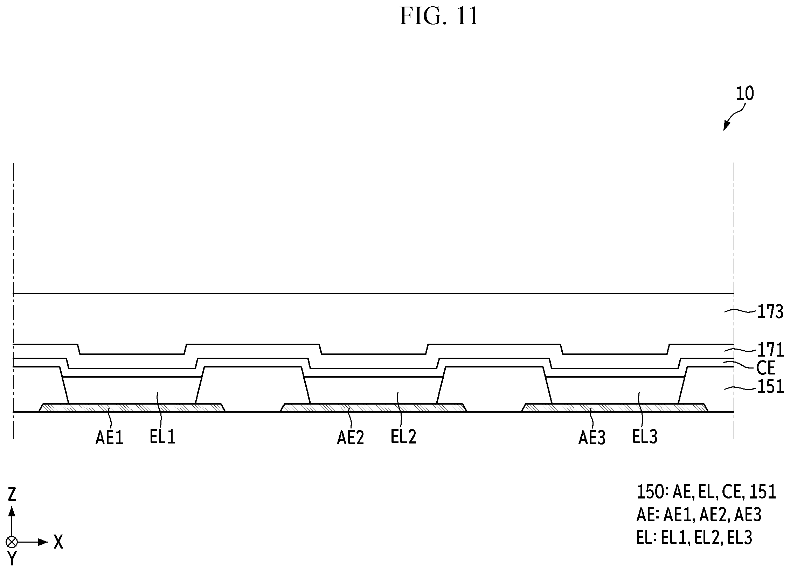

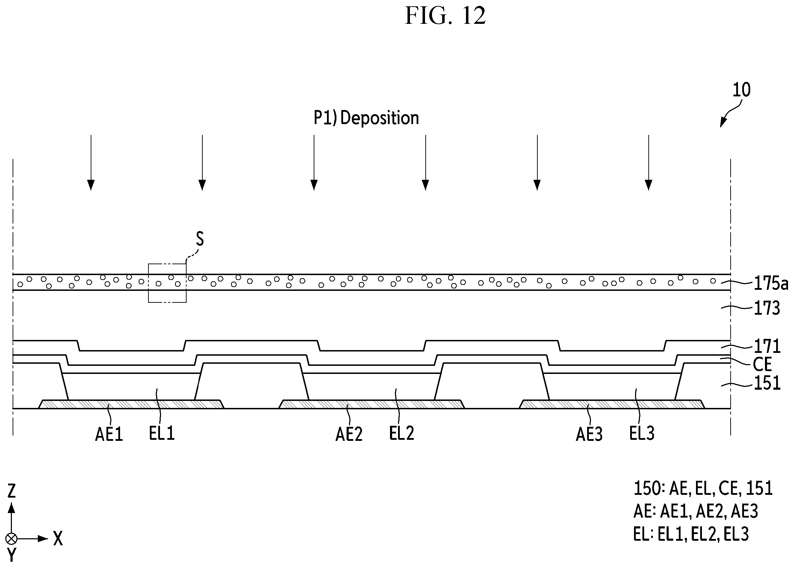

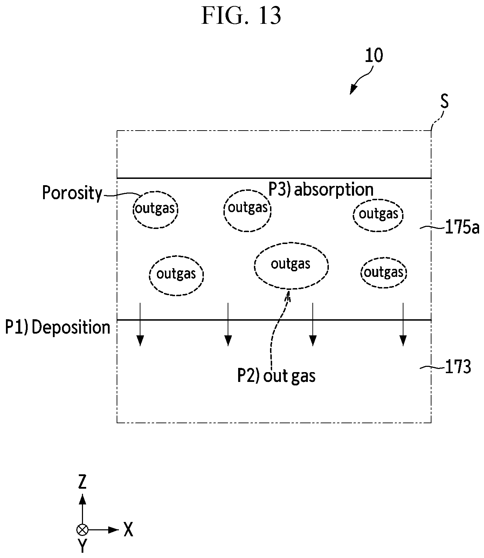

FIGS. 11 and 12 are cross-sectional views showing an embodiment of a process of fabricating a thin-film encapsulation layer. FIG. 13 is an enlarged cross-sectional view of area S of FIG. 12.

Referring to FIGS. 11 to 13, in an embodiment, a first encapsulation layer 171 and a second encapsulation layer 173 are formed on the display element layer 150. The structures and characteristics of the display element layer 150, the first encapsulation layer 171 and the second encapsulation layer 173 are substantially the same as those described above with reference to FIG. 4, and any repetitive detailed descriptions thereof will be omitted.

Subsequently, a first layer 175a of the third encapsulation layer 175 is formed on the second encapsulation layer 173. Hereinafter, a process of forming the first layer 175a and the reaction inside the film will be described in order.

In an embodiment, the first layer 175a is deposited to be in contact with the second encapsulation layer 173 (P1 in FIG. 12). The first layer 175a may be formed by a chemical vapor deposition (CVD) process. The process of forming the first layer 175a may be a deposition process using high-energy plasma.

The first layer 175a includes a plurality of pores. The deposition conditions set for the first layer 175a to have pores may be determined by adjusting the amounts of reaction gases such as silane gas, hydrogen gas, ammonia gas and nitrogen gas under a low power condition.

In such an embodiment, during deposition of the first layer 175a, the second encapsulation layer 173 may release outgas due to the high energy plasma used to form the first layer 175a (P2 in FIG. 13). A part of the outgas may be removed by a fume hood inside the deposition chamber forming the first layer 175a, but some of the outgas may remain in the display device 10.

In such an embodiment, since the first layer 175a has a plurality of pores therein, the remaining outgas can be absorbed into the pores of the first layer 175a (P3 in FIG. 13).

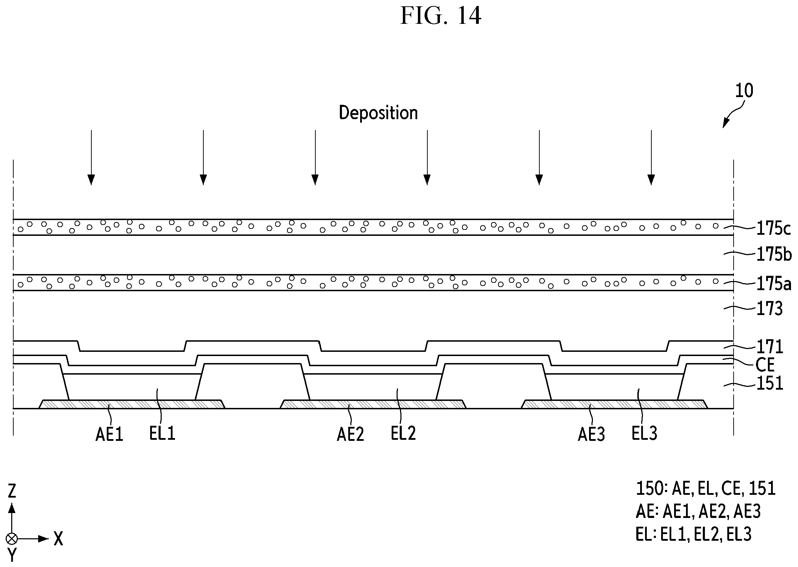

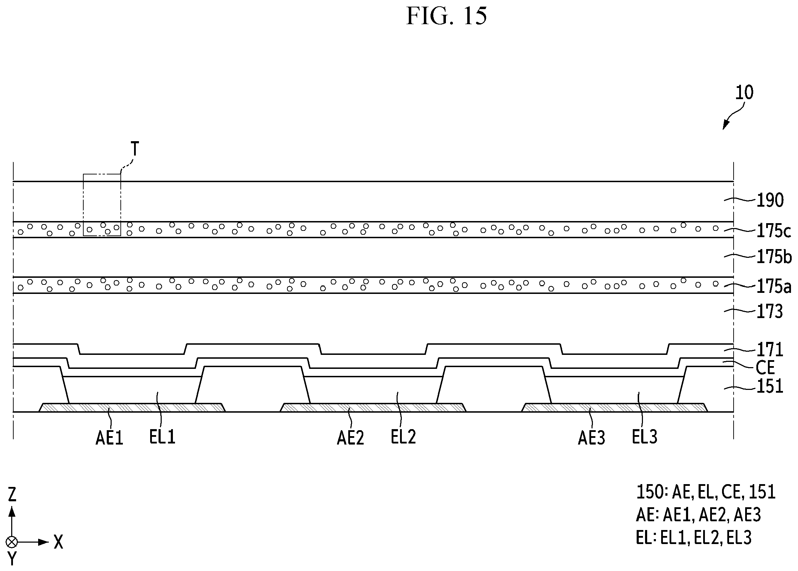

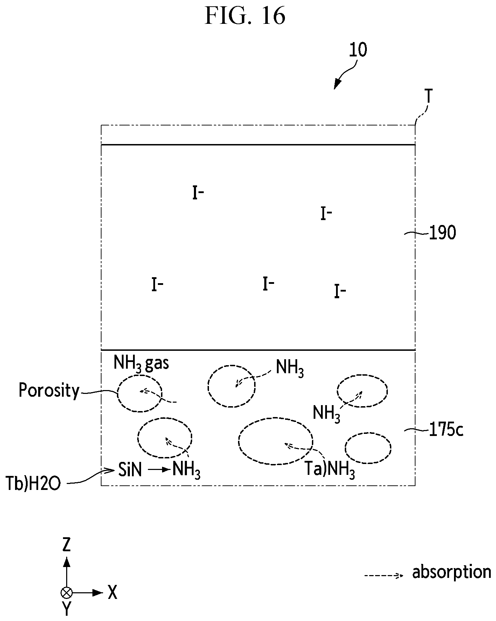

FIGS. 14 and 15 are cross-sectional views showing a process of fabricating the thin-film encapsulation layer and the polarizing film of FIG. 4. FIG. 16 is an enlarged, cross-sectional view of area T of FIG. 15.

Subsequently, referring to FIGS. 14 to 16, a second layer 175b is deposited on the first layer 175a of the third encapsulation layer 175. In this process, the deposition conditions set for the second layer 175b to have pores may be determined by adjusting the amounts of reaction gases such as silane gas, hydrogen gas, ammonia gas and nitrogen gas under a power condition higher than the deposition process of forming the first layer 175a.

Through this process, the second layer 175b of the third encapsulation layer 175 can have a higher film density and higher oxygen content than the first layer 175a. In such an embodiment, as described, the second layer 175b has denser film properties than the first layer 175a. Any repetitive detailed descriptions thereof will be omitted.

Subsequently, a third layer 175c is deposited on the second layer 175b of the third encapsulation layer 175.

The third layer 175c includes a plurality of pores inside. The deposition conditions set for the third layer 175c to have pores may be determined by adjusting the amounts of reaction gases such as silane gas, hydrogen gas, ammonia gas and nitrogen gas under a low power condition.

Although the first layer 175a, the second layer 175b and the third layer 175c may be formed separately in an embodiment shown in the drawings, the first layer 175a, the second layer 175b and the third layer 175c may be performed consecutively in a same chamber. In such an embodiment, the first layer 175a, the second layer 175b and the third layer 175c may be performed in a same chamber by only changing the deposition conditions. Therefore, the display device 10 according to an embodiment can be easily fabricated.

Lastly, a polarizing film 190 is attached on the entire surface of the third layer 175c. Hereinafter, the internal reaction of the film of the third layer 175c will be described.

Referring to FIG. 16, in an embodiment, the third layer 175c may include ammonia gas (NH₃ gas) on the inside or surface. The ammonia gas (NH₃ gas) included in the third layer 175c may be divided into a first type Ta and a second type Tb. The first type Ta may be a part of the reaction gas that failed to be silicon nitride and remains during the process of forming the third layer 175c. On the other hand, the second type Tb may be formed due to the reaction between moisture (H₂O) introduced from the outside and silicon nitride (SiN). The first type Ta and the second type Tb may be the same ammonia gas (NH₃ gas) even though the first type Ta and the second type Tb are generated differently. In such an embodiment, as described above, if the ammonia (NH₃) gas contained in the third layer 175c reacts with the iodine ion (I-) contained in the polarizing film 190, the polarizing film 190 may be discolored and thus the reliability of the display device 10 may be deteriorated.

Accordingly, in the display device 10 according to an embodiment of the disclosure, the ammonia (NH₃) gas may be effectively absorbed in the pores of the third layer 175c such that the ammonia (NH₃) gas remaining inside the third layer 175c does not react with the iodine ion (I-) contained in the polarizing film 190.

In this manner, the thin-film encapsulation layer 170 and the polarizing film 190 shown in FIG. 4 can be formed.

In the display device 10 according to an embodiment of the disclosure, the inorganic insulating film having pores is formed to be in direct contact with the film containing the organic material, such that the reaction material generated in the film containing the organic material can be absorbed in the pores. In this manner, it is possible to improve the reliability of the display device 10 according to an embodiment.

The display device according to one embodiment of the present disclosure can be applied to various electronic devices. The electronic device according to the one embodiment of the present disclosure includes the display device described above, and may further include modules or devices having additional functions in addition to the display device.

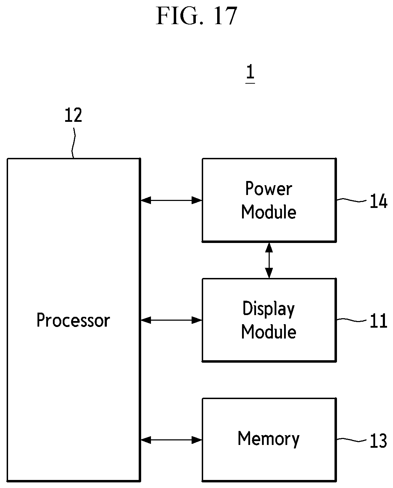

FIG. 17 is a block diagram of an electronic device according to one embodiment of the present disclosure.

Referring to FIG. 17, the electronic device 1 according to one embodiment of the present disclosure may include a display module 11, a processor 12, a memory 13, and a power module 14.

The processor 12 may include at least one of a central processing unit (CPU), an application processor (AP), a graphic processing unit (GPU), a communication processor (CP), an image signal processor (ISP), and a controller.

The memory 13 may store data information necessary for the operation of the processor 12 or the display module 11. When the processor 12 executes an application stored in the memory 13, an image data signal and/or an input control signal is transmitted to the display module 11, and the display module 11 can process the received signal and output image information through a display screen.

The power module 14 may include a power supply module such as, for example a power adapter or a battery, and a power conversion module that converts the power supplied by the power supply module to generate power necessary for the operation of the electronic device 1.

At least one of the components of the electronic device 1 according to the one embodiment of the present disclosure may be included in the display device 10 according to the embodiments of the present disclosure. In addition, some modules of the individual modules functionally included in one module may be included in the display device 10, and other modules may be provided separately from the display device 10. For example, the display device 10 may include the display module 11, and the processor 12, the memory 13, and the power module 14 may be provided in the form of other devices within the electronic device 1 other than the display device 10.

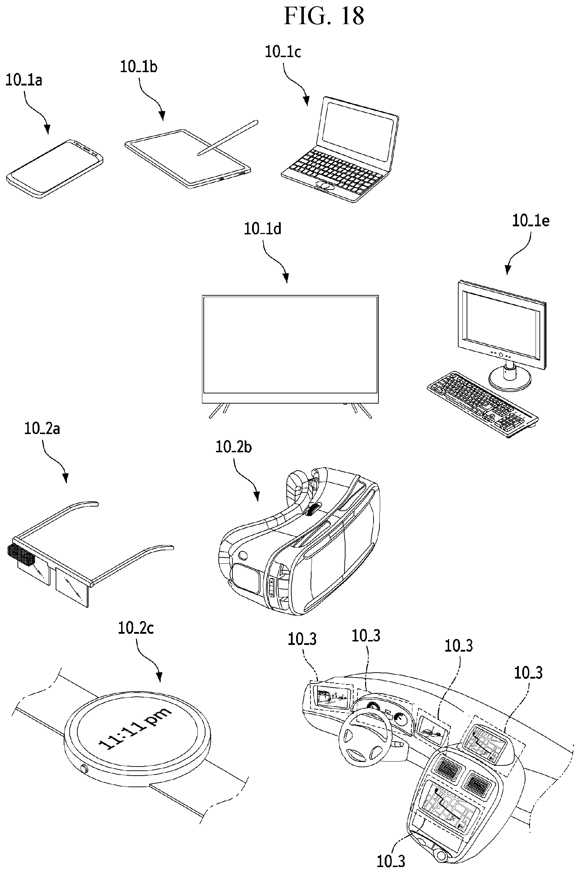

FIG. 18 is a schematic diagram of an electronic device according to various embodiments of the present disclosure.

Referring to FIG. 18, various electronic devices to which display devices 10 according to embodiments of the present disclosure are applied may include not only image display electronic devices such as a smart phone 10_1a, a tablet PC (personal computer) 10_1b, a laptop 10_1c, a TV 10_1d, and a desk monitor 10_1e, but also wearable electronic devices including display modules such as, for example smart glasses 10_2a, a head mounted display 10_2b, and a smart watch 10_2c, and vehicle electronic devices 10_3 including display modules such as a CID (Center Information Display) and a room mirror display arranged on a dashboard, center fascia, and dashboard of an automobile.

Although embodiments of the disclosure have been described with reference to the accompanying drawings, those skilled in the art would understand that various modifications and alterations may be made without departing from the technical idea or essential features of the disclosure. Therefore, it should be understood that the above-mentioned embodiments are not limiting but illustrative in all aspects.

The invention should not be construed as being limited to the embodiments set forth herein. Rather, these embodiments are provided so that this disclosure will be thorough and complete and will fully convey the concept of the invention to those skilled in the art.

While the invention has been particularly shown and described with reference to embodiments thereof, it will be understood by those of ordinary skill in the art that various changes in form and details may be made therein without departing from the scope of the invention as defined by the following claims.

## Claims

1. A display device (10) comprising:
a substrate (110) comprising an emission area (EA) and a non-emission area (NLA);
a display element layer (150) comprising an emissive layer (EL) disposed on the emission area (EA) of the substrate (110);
a thin-film encapsulation layer (170) disposed on the display element layer (150), wherein the thin-film encapsulation layer (170) comprises a first encapsulation layer (171), a second encapsulation layer (173), and a third encapsulation layer (175); and
a polarizing film (190) disposed on the thin-film encapsulation layer (170),
wherein the third encapsulation layer (175) comprises:
a first layer (175a) having pores;
a second layer (175b) disposed on the first layer (175a) and having a higher film density than the first layer (175a); and
a third layer (175c) disposed on the second layer (175b) and having pores.

2. The display device (10) of claim 1, wherein each of the first layer (175a), the second layer (175b) and the third layer (175c) comprises oxygen-doped silicon nitride.

3. The display device (10) of claim 2, wherein the third layer (175c) has a lower film density than the second layer (175b).

4. The display device (10) of claim 3, wherein
a film density of each of the first layer (175a) and the third layer (175c) is equal to or less than about 1.9 g/cm³, and
a film density of the second layer (175b) is equal to or greater than about 1.9 g/cm³ and equal to or less than about 2.2 g/cm³.

5. The display device (10) of claim 4, wherein:
(i) the first layer (175a) and the third layer (175c) have a compressive stress of about -200 MPa or less, and
the second layer (175b) has a compressive stress in a range of about -250 MPa to about -150 MPa; and/or
(ii) the second layer (175b) has a porosity lower than a porosity of the first layer (175a) and a porosity of the third layer (175c).

6. The display device (10) of any one of claims 1 to 5, wherein
an oxygen content of the second layer (175b) is in a range of about 10% to about 20%, and
an oxygen content of the first layer (175a) and the third layer (175c) is equal to or less than about 10%.

7. The display device (10) of any one of claims 1 to 6, wherein a thickness (Ha) of the first layer (175a) and a thickness (Hc) of the third layer (175c) are less than a thickness (Hb) of the second layer (175b).

8. The display device (10) of claim 7, wherein:
(i) the thickness (Ha) of the first layer (175a) and the thickness (Hc) of the third layer (175c) are in a range of about 10% to about 15% of a total thickness (H175) of the third encapsulation layer (175); and/or
(ii) the pores of the first layer (175a) are uneven, and
the pores the third layer (175c) are uneven.

9. The display device (10) of any one of claims 1 to 8, wherein
the second encapsulation layer (173) comprises an organic material, and
the polarizing film (190) comprises an iodine ion.

10. The display device (10) of claim 9, wherein
the first layer (175a) is in contact with the second encapsulation layer (173), and
the third layer (175c) is in contact with the polarizing film (190).

11. The display device (30) of any one of claims 1 to 9, further comprising:
a touch sensor layer (180) disposed between the thin-film encapsulation layer (170) and the polarizing film (190),
wherein the touch sensor layer (180) comprises a first touch layer (183d) and a second touch layer (183e) disposed on the first touch layer (183d),
wherein the second touch layer (183e) has pores, and is in contact with the polarizing film (190), and
wherein a film density of the second touch layer (183e) is lower than a film density of the first touch layer (183d), optionally wherein
the film density of the first touch layer (183d) is equal to or greater than about 1.9 g/cm³ and equal to or less than about 2.2 g/cm³, and
the film density of the second touch layer (183e) is equal to or less than about 1.9 g/cm³.

12. An electronic device (1) comprising:
a display panel (100) comprising a display area (DA) and a non-display area (NDA) surrounding the display area (DA), wherein the display area (DA) comprises a substrate (110) comprising an emission area (EA) and a non-emission area (NLA);
a display element layer (150) comprising an emissive layer (EL) disposed on the emission area (EA) of the substrate (110);
a thin-film encapsulation layer (170) disposed on the display element layer (150), wherein the thin-film encapsulation layer (170) comprises a first encapsulation layer (171), a second encapsulation layer (173), and a third encapsulation layer (175); and
a polarizing film (190) disposed on the thin-film encapsulation layer (170),
wherein the third encapsulation layer (175) comprises:
a first layer (175a) having pores;
a second layer (175b) disposed on the first layer (175a) and having a higher film density than the first layer (175a); and
a third layer (175c) disposed on the second layer (175b) and having pores.

13. A method for fabricating a display device (10), the method comprising:
forming a first encapsulation layer (171) containing an inorganic material on a substrate (110), forming a second encapsulation layer (173) containing an organic material on the first encapsulation layer (171), and then forming a third encapsulation layer (175) comprising a plurality of different layers on the second encapsulation layer (173); and
forming a polarizing film (190) on the third encapsulation layer (175),
wherein the third encapsulation layer (175) comprises:
a first layer (175a) in contact with the second encapsulation layer (173) and having pores;
a second layer (175b) disposed on the first layer (175a) and having a higher film density than the first layer (175a); and
a third layer (175c) disposed on the second layer (175b) and in contact with the polarizing film (190) and having pores.

14. The method of claim 13, wherein the first layer (175a) absorbs outgas generated in the second encapsulation layer (173) in the pores thereof.

15. The method of claim 14, wherein a film density of the third layer (175c) is lower than a film density of the second layer (175b), optionally wherein the third layer (175c) absorbs ammonia (NH₃) gas in the pores thereof, further optionally wherein the forming the third encapsulation layer (175) comprises: forming the first layer (175a), the second layer (175b) and the third layer (175c) in a same chamber.
